# EUROPEAN PATENT APPLICATION

(11) **EP 2 009 967 A2**
(43) Date of publication of application: **31.12.2008**
(21) Application number: 08158496.3
(22) Date of filing: 18.06.2008
(51) Int. Cl.: H05K 1/02, H05K 3/20

(54) **Wiring board and bus bar segments to be used therefor**

(30) Priority: 27.06.2007 JP 2007168563
(71) Applicant: Kabushiki Kaisha T AN T, Kawagoe-shi Saitama (JP)
(72) Inventor: Soga, Hisashi, Kawagoe-shi Saitama (JP); Kawagoe, Junji, Kawagoe-shi Saitama (JP)
(74) Representative: Henkel, Feiler & Hänzel

(57) **Abstract**

A wiring board formed with electric circuits is provided, wherein said electric circuits are formed by comprising straight bus bar segments (11-13), each of the straight bus bar segments having contact portions (11a-13a) at opposite ends thereof, said wiring board having means for bringing the respective contact portions into electrical contact.

## Description

### BACKGROUND OF THE INVENTION

### Field of the Invention

The present invention relates to a wiring board formed with electric circuits composed of bus bar segments to be used therefor, wherein standardized bus bar segments are arranged in series in a circuit pattern formed for electric connection of contact portions of each bus bar segments in the wiring board, for example, in the back face of a housing for an automobile room lamp system.

### Description of the Related Art

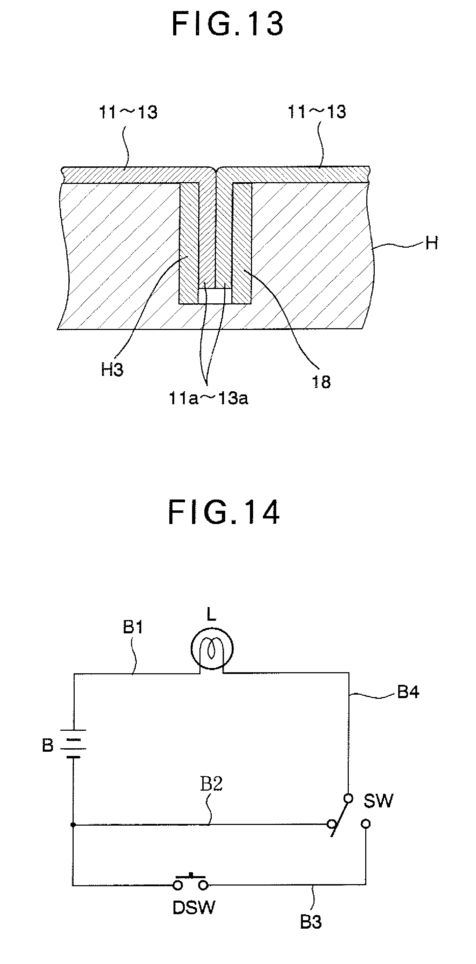

The conventional circuit of a one-lamp type automobile room lamp is composed of a plurality of bus bars inserted into grooves in a back face of the wiring board as a housing for ON-OFF control of the lamp in the circuit as shown by Fig. 14. The circuit is composed of a direct current power source B (hereinafter merely referred to as power source), a door switch DSW adapted to be turned on when a door is opened, a switch SW such as a push switch or slide switch to be operated by the driver and a lamp L of the automobile room lamp.

In this circuit, when the movable contact takes the position shown in the figure, the lamp L is lighted regardless of the ON-OFF position of the door switch DSW. On the other hand, when the driver operates the switch SW such that movable contact thereof is switched to the opposite fixed contact side, the lamp L is lighted with the door switch DSW taking the ON position by the opening of the door.

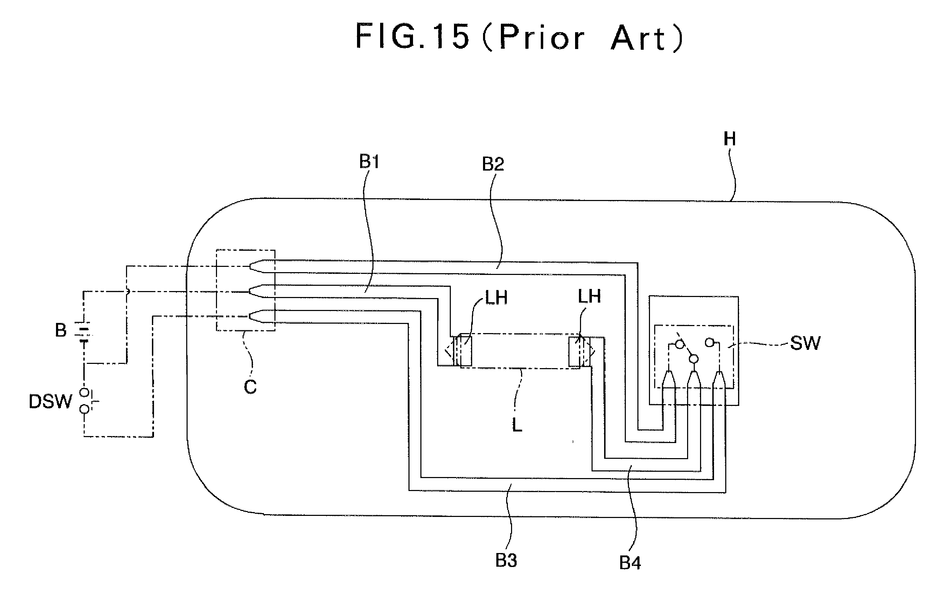

Then, one example of the circuit in such automobile room lamp system using bus bars for the wiring board H is shown in Fig. 15. It is to be noted in this connection that since similar numerals are used for similar members to the aforementioned circuit, explanation thereof will be omitted.

The numeral C denotes a connector secured to the housing to connect the door switch DSW and bus bars while the numeral LH denotes a pair of lamp holders to hold the lamp L to the housing. Then, the bus bars to connect the connector C, the lamp holder LH and the switch SW are configured as explained hereinafter.

More specifically, the bus bars include bus bar B1 to connect the first one of the terminals of the connector C and the first one of the lamp holders LH, bus bar B2 to connect the second one of the terminals and the first one of the fixed contact of the switch SW, bus bar B3 to connect the third one of the terminals and the second one of the fixed contact of the switch SW and bus bar B4 to connect the second one of the lamp holder LH and the movable contact of the switch SVLT. The respective bus bars are inserted into grooves formed in the wiring board H.

In the afore mentioned switch board H mounted with the four bus bars B1 through B4, said bus bars are required to have various shapes (such as many bent portions) in order to establish connection between the connector C, the lamp holder LH of the lamp L and the switch SW. As a result, waste materials of large dimension are left after the manufacture of bus bars by punching or blanking, thus raising the material cost.

Further, the mounting of bus bars having complicated shapes onto the wiring board H makes automation so difficult that bus bars must be mounted onto the wiring board one by one through laborious manual work before automated press fit is done to secure the bus bars in the grooves in the wiring board H to prevent their slip off. Further, the complicated circuit configuration as observed in the two-lamp type automobile room lamp lighting system accelerates the increase of the number of bus bars which needs manual work with the result that the manufacture of one unit of the automobile room lamp lighting system needs more cost due to prolonged labor hour.

In order to solve such a problem, an invention as disclosed in Japanese Patent Application Laid Open to the Public H5-207627 is provided. In said invention, bus bars composing a circuit network are punched out at a time in the form of an integral sheet in which the bus bars are connected through connecting portions and the thus punched out integral bus bars are manually mounted onto the wiring board before the bus bars are automatically press fit and severed and separated at the connecting portions thereof to form a desired wiring network.

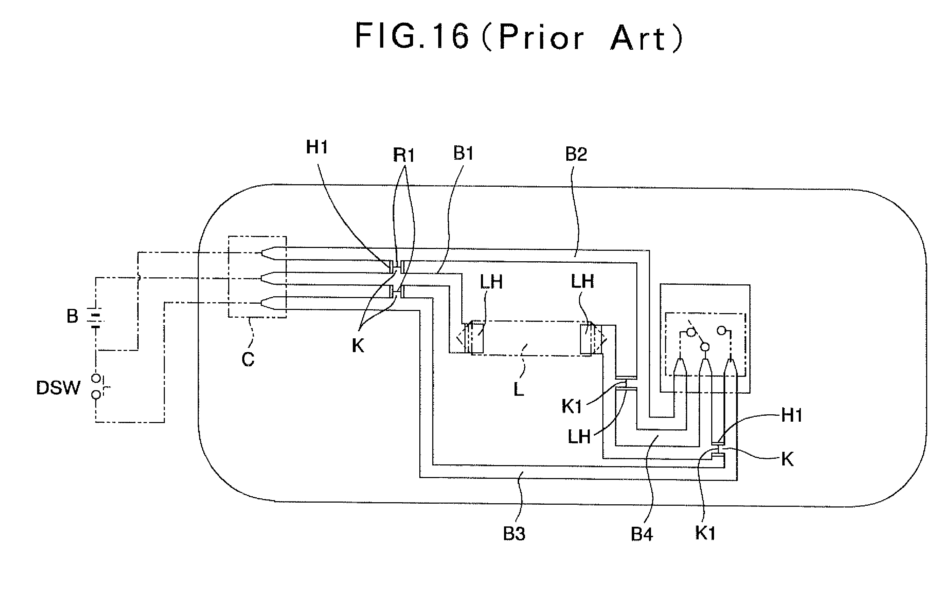

Fig. 16 shows bus bars which completes the circuits shown in Fig. 14 by making use of the above art. It is to be noted that the similar numerals denote similar members and explanation thereof will be omitted.

The respective bus bars B1 to B4 are manufactured by punching out at a time integrated bus bars connected by way of four connecting portions K each having a cut mark K1. It is to be noted in this connection that although this embodiment discloses four bus bars B1 to B4 connected by way of four connecting portions, said bus bars are preferably connected by more connecting portions to prevent possible deformation of the bus bars if connected by the four connecting portions. Furthermore, said wiring board H is formed with a hole H1 therein to facilitate the severing at the cut marks K1 and receive bent connecting portions.

The thus structured integral bus bars are provisionally inserted into the grooves in the wiring board H by manual work before the bus bars are subjected to the automated press fitting of the integral four bus bars into the groove as well as the severing/bending operation all at a time to form the separated four bus bars constituting four circuits while the connecting portions H are bent and forced into the holes H to assure the fixation thereof by said press fitting of the respective bus bars B1 to B4 into the grooves and forcing of the connecting portions H into the hole H1. In this case, however, it is inevitable that waste materials of large dimensions are left in the manufacture of bus bars by punching or blanking.

Although the wiring board H making use of the aforementioned integrated bus bars can contribute to reducing the production time as compared to independent bus bars separately loaded onto the wiring board H by manual work, such integrated bus bars inevitably produce at the time of punching out the same from a sheet of metal material, piling up material costs. Furthermore, the complicated circuit configuration causes plural sets of the integrated bus bars to interfere each other at the time of being loaded onto the wiring board H to make the sorting operation troublesome. In order to prevent the mutual interference of the integrated bus bars, it was proposed to tidy up such bus bars into boxes before they are supplied to the operator but such measure also requires additional labor force. Further, even more complicated circuit configuration makes the designing of the integrated bus bars even more difficult.

### SUMMARY OF THE INVENTION

It is therefore an object of the invention to cut down on waste materials and realize the reduction of material costs by preparing linear bus bar segments having standardized lengths and girths in a serial train such that the manufacture of said segments will not lead to the production of waste materials at the time of punching out from a planar electrically conductive metal plate material. It is also possible to configure any circuit designs by sequentially connecting said standardized segments while by interposing standardized corner segments with the result that wiring boards using bus bar segments of even more complicated circuit configuration are provided.

In order to accomplish the above objects, the present invention provides a wiring board having circuit configuration based on the electric circuit by incorporating the means as claimed in claim 1, wherein said electric circuits are formed by comprising straight bus bar segments, each of the straight bus bar segments having contact portions at opposite ends thereof, said wiring board having means for bringing the respective contact portions into electrical contact.

The present invention further provides a wiring board formed with electric circuits by incorporating the means as claim in claim 2, wherein said electric circuits are formed by comprising straight bus bar segments, each of the respective straight-line bus bar segments having contact portions bent at right angles at opposite ends thereof, said wiring board having insertion holes formed to receive the respective contact portions for bringing said respective contact portions into electrical contact.

The present invention further provides a wiring board formed with electric circuits by incorporating the means as claim in claim 3, wherein said electric circuits are formed by comprising straight bus bar segments and corner bus bar segments, each of said straight bus bar segments and said corner bus bar segments having contact portions at opposite ends thereof, said wiring board having insertion corner holes formed to receive the respective contact portions for bringing said respective contact portions into electrical contact.

The present invention further provides a wiring board as claimed in claim 4, wherein said corner bus bar segment are T-shaped and have contact portions at respective opposite ends thereof to be received into said insertion corner holes.

The present invention further provides a wiring board as claimed in claim5, wherein said corner bus bar segment are T-shaped and have contact portions at respective opposite ends thereof to be received into said insertion corner holes.

The present invention further provides a wiring board as claimed in claim 6, wherein said corner bus bar segments are cross-shaped and have contact portions at respective opposite ends thereof to be received into said insertion corner holes.

The present invention further provides a wiring board as claimed in claim 7, wherein said corner bus bar segment has a square top surface having four sides, at least two of said four sides being formed with contact portions extending therefrom to be received into said insertion corner holes.

The present invention further provides a wiring board as claimed in claim 8, wherein said corner bus bar segments are formed with at least two contact portions to be received into said insertion corner holes formed in said wiring board, each of said insertion corner holes including at least two holes combined into one to extend at a right angle for defining a corner configuration.

The present invention further provides a wiring board as claimed in claim 9, wherein said wiring board is formed with guide grooves to guide said straight bus bar segments and said corner bus bar segments, said insertion holes being in said guide grooves.

The present invention further provides a wiring board as claimed in claim 10, wherein each insertion hole has an entry opening relatively wide but becoming increasingly narrow in a direction in which the tip end of the contact portion proceeds such that said contact portions inserting into said insertion hole are press fit to each other toward their tip ends.

The present invention further provides a wiring board as claimed in claim 11, wherein each contact portions of the straight bus bar segments and the corner bus bar segments is embossed to have at least one protuberance such that when the contact portions of the straight bus bar segments and the contact portions of the corner bus bar segments are inserted into said insertion holes, the protuberance of each mating contact portion are press fit to the flat surface of other mating contact portion to assure the contact therebetween.

The present invention further provides a wiring board as claimed in claim 12, wherein an oval is inserted into the insertion holes to assure that the forcibly inserted contact portions of straight bus bar segments each other and the inserted contact portions of straight bus bar segments and corner bus bar segments are brought into positive press fit each other.

The present invention further provides a wiring board as claimed in claim 13, wherein all of said straight bus bar segments are of equal length and width.

The present invention provides a bus bar arrangement in a wiring board as claimed in claim 14, comprising a plurality of standardized straight bus bar segments of different lengths and widths, each straight bus bar segment having contact portions bent at its opposite ends; and corner bus bar segments of equal widths to said straight bus bar segments, each corner bus bar segment having contact portions bent at their ends, said corner bus bar segments being L-shaped, T-shaped and cross shaped, respectively.

The present invention further provides a bus bar segment arrangement in a wiring board as claimed in claim 15, comprising a plurality of standardized straight bus bar segments of different lengths and widths, each straight bus bar segment having contact portions bent at its opposite ends; and corner bus bar segments of equal widths to said straight bus bar segments, each corner bus bar segment having a top portion in square flat form and at least two contact portions extending from two neighboring side of said top portion and bent in an uniform direction.

The present invention further provides a bus bar arrangement in a wiring board as claimed in claim 16, comprising a plurality of standardized straight bus bar segments of different lengths and widths, each straight bus bar segment having contact portions bent at its opposite ends; and corner bus bar segments of equal widths to said straight bus bar segments, each corner bus bar segment having at least two contact portions bent at a right angle.

The present invention further provides a bus bar arrangement in a wiring board as claimed in claim 17, wherein said straight bus bar segments and said corner bus bar segments are embossed to have protuberances in positions not to interfere with each other.

### BRIEF DESCRIPTION OF THE DRAWINGS

Fig. 1 is a plan view of the wiring board incorporated with bus bar segments of the present invention;
Fig. 2 is a perspective view of the wiring board with the bus bar segments being mounted thereonto;
Fig. 3 (a) and Fig. 3 (b) are cross sections of the bus bar segments being connected to each other, in which Fig. 3 (a) is a cross section of the connecting portions of bus bar segments being inserted into an insertion hole while Fig. 3 (b) is a cross section of the connection portions of bus bar segments having been inserted;
Fig. 4 is a perspective view showing the insertion work having been completed;
Fig. 5 is a perspective view of a lamp holder for holding the lamp;
Fig.6 (a) and Fig.6 (b) are examples of corner bus bar segments, in which Fig. 6 (a) is a perspective view of a T-shape corner bus bar segment while Fig. 6 (b) is a perspective view of the cross-shaped corner bus bar segment;
Fig. 7 is a perspective view of assembly work being done by use of another corner bus bar segments;
Fig. 8 is a cross section of the main portions of the assembled segments as shown in Fig. 7;
Fig. 9 is a further perspective of the assembly work being done by use of a further corner bus bar segments;
Fig. 10 is a cross section of the main portions of the assembled segments as shown in Fig. 9;
Fig. 11 is a still further perspective view of another embodiment of straight bus bar segments;
Fig. 12 is a cross section showing the straight bus bar segment having been inserted into the insertion hole;
Fig. 13 is a still further cross section showing straight bus bar segments having been inserted into the insertion holes;
Fig. 14 is a circuit diagram showing one example of automobile room lamp lighting system adopted in the present invention;
Fig. 15 is a plan view of the conventional multiple bus bars assembled onto the wiring board; and
Fig. 16 is a plan view of the conventional multiple bus bars connected by connecting portions into an integral bus bar having been assembled into the wiring board.

### DETAILED DESCRIPTION OF THE PREFERRED EMBODIMENTS

The present invention relates to a wiring board formed with a circuit configured by comprising straight bus bar segments each having bent contact portions at opposite ends thereof, said bent contact portions being press fit into insertion holes formed in said wiring board such that the bent contact portions are brought into electrical contact.

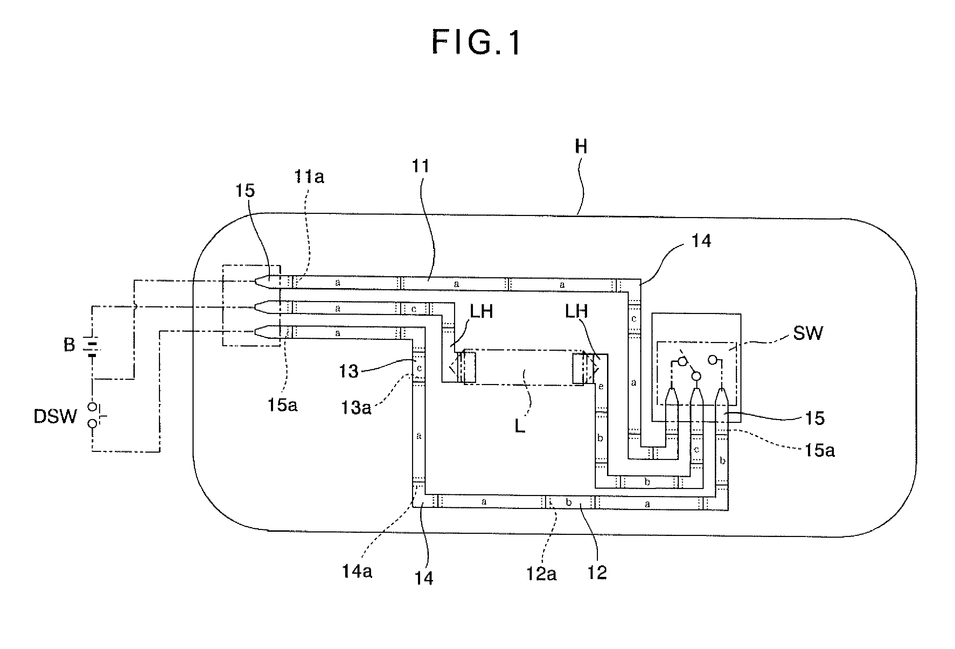

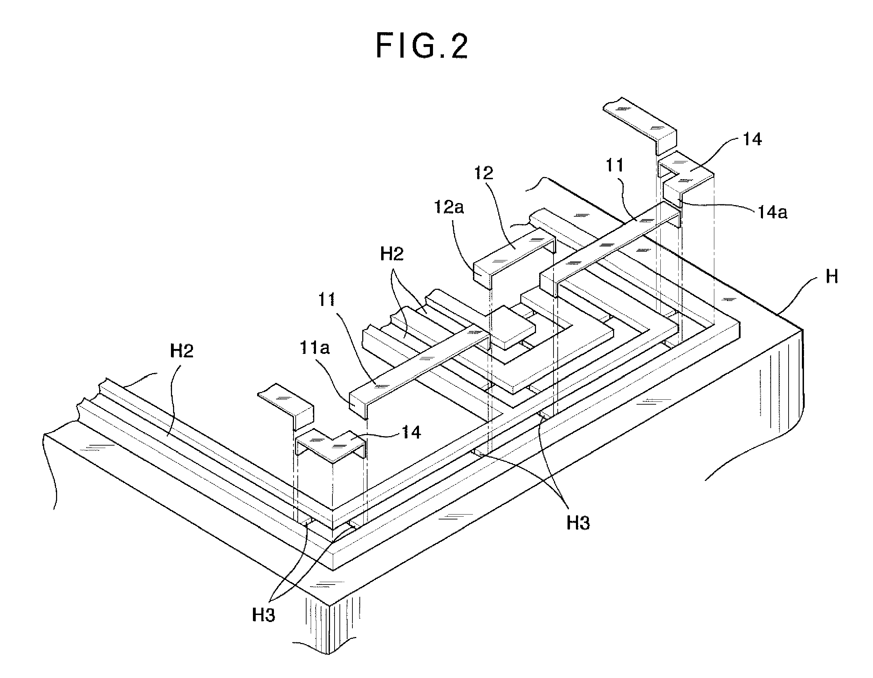

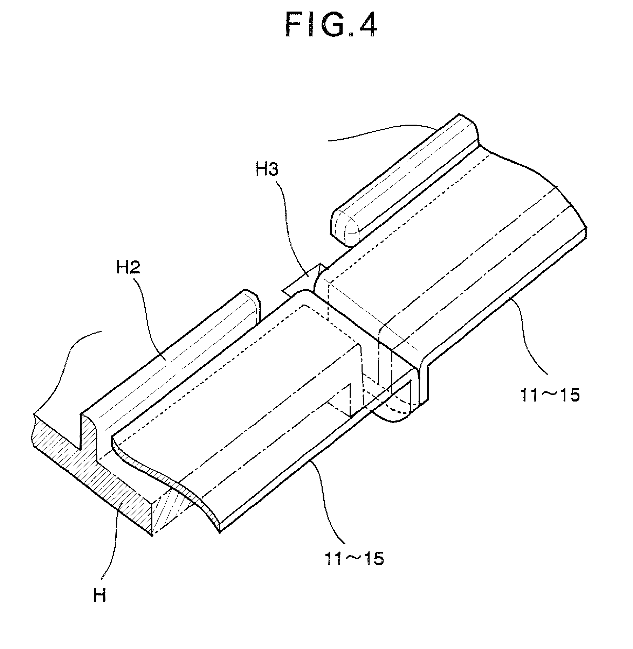

Hereinafter, the embodiments of the wiring board and bus bar segments used therewith according to the present invention will be explained with reference to Fig. 1 to Fig. 6.

The present invention is characterized in being configured by three types of standardized straight bus bar segments 11 to 13 having respectively different lengths, L-shaped corner bus bar segments 14 and connector terminals 15 having pointed tips for connecting a switch box SW or a connector of the door switch DSW.

The opposite ends of said straight bus bar segments 11 to 13 and said corner bus bar segments 14 are bent at a right angle to form contact portions 11a to 14a. On the other hand, the wiring board H are formed with guide grooves H2 therein to guide the straight bus bar segments 11 to 13, the corner bus bar segments 14 and the connector terminals 15, where said guide grooves H2 are formed with insertion holes H3 for receiving said contact portions 11a to 15a to connect the inserted contact portions 11a to 15a each other such that a circuit is configured.

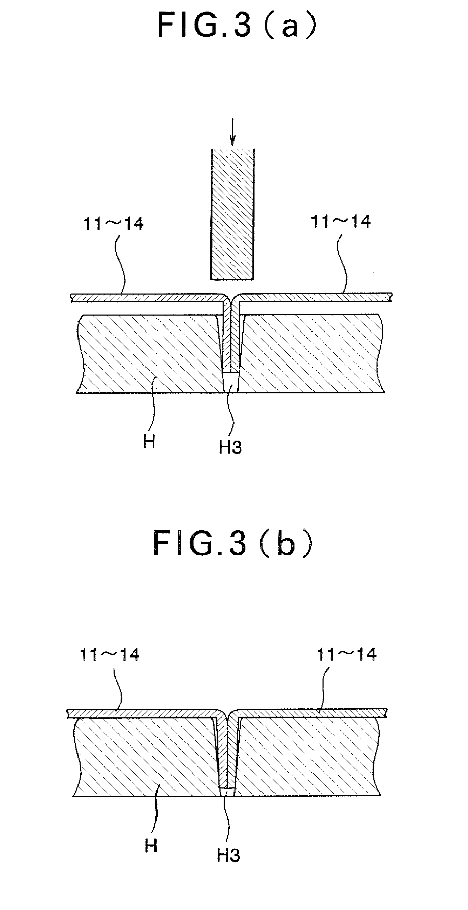

As shown in Fig. 3, each insertion hole H3 has an entry opening relatively wide but becoming increasingly narrower in a direction in which the tip end of the contact portion proceeds such that said contact portions inserting into said insertion hole are press fit to each other toward their tip end. While each of the straight bus bar segments 11 thought 13, corner bus bar segments 14 and connector terminals 15 is guided within a relevant guide groove H2, the contact portions 11a through 13a of the straight bus bar segments are inserted into the respective insertion holes H3 such that said contact portions 11a through 13a are brought into press fit contact each other within the converging insertion holes H3. Similarly, since the contact portions 14a of the corner bus bar segments 14 are also inserted into the respective insertion holes H3, said contact portions 14a are brought into press fit with the contact portion 11a to 13a of the straight bus bar segments 11 to 13. Similarly, since the contact portions 15a of the connector terminal 15 are also inserted into the respective holes H3, said contact portions 15a are brought into press fit with the contact portions 11a to 13a of the straight bus bar segments 11 to 13. Therefore, the contact portions fully inserted into the insertion holes H3 assures full electrical contact to prevent insufficient contact due to vibrations.

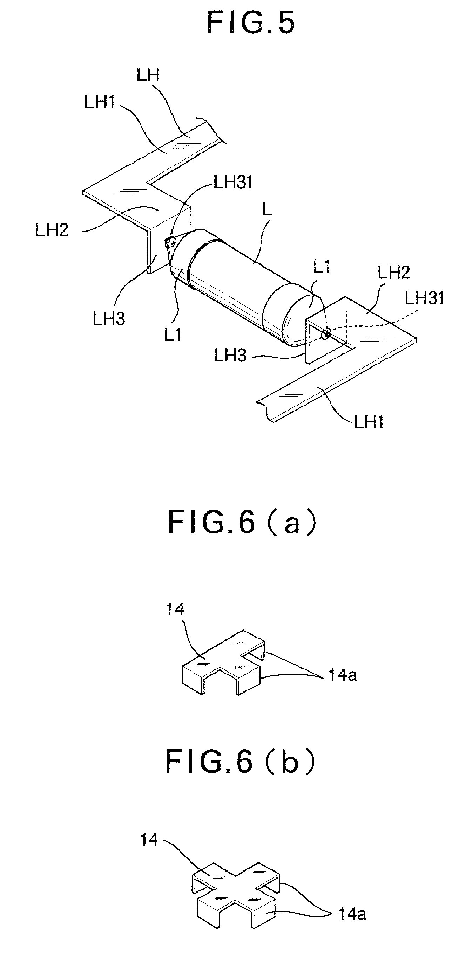

For holding the lamp L, in this connection, a lamp holder LH having a configuration as shown in Fig. 5 is used. That is, the holder LH has a first portion LH1, a second portion LH2 horizontally extending in the same plane as and at a right angle with respect to said first portion, and a third portion LH3 bent downward vertically from said second portion LH2, said third portion LH3 having a hole L31 formed therein to receive the tip of the conical portion L1 of the lamp L for holding the same.

Then, said first portions LH1 have contact portions at their ends to be connected to the contact portions 11a through 13a of the straight bus bar segments, said third portions LH3 being disposed in a recess (not shown) formed in the wiring board to accommodate the Lamp L, wherein the tips of the conical portions L1 of the lamp L are snap fitted into the holes LH31 to resiliently hold the lamp L therein.

Further, since guiding the straight bus bar segments 11 to 13, the corner bus bar segments 14 and the connector terminals 15 into the guide holes H2 formed in the wiring board H as well as inserting the contact portions 11a to 15a into the insertion holes H3 is done all at once automatically, the setting of the bus bar segments is performed without needing laborious man power, thus reducing the production cost.

In the previous embodiment, the use of the L-shaped corner bus bar segments 14 is explained. However, since a straight bus bar segment can meet or cross another straight bus bar segment at a right angle depending on circuit configuration, a T-shaped segment 14 having a contact portion 14a extending downward from each side thereof as shown in Fig. 6 (a) or a cross-shaped segments 14 extending downward from each side thereof as shown in Fig. 6 (b) may be prepared, allowing any design of circuit configuration.

Further in the previous embodiment, each bus bar segment 11 to 15 is guided in the guide groove H1, such guide groove H1 is not essentially needed because the contact portions 11a through 15a of each bus bar segment 11 through 15 are inserted into the insertion holes H3, where they are secured.

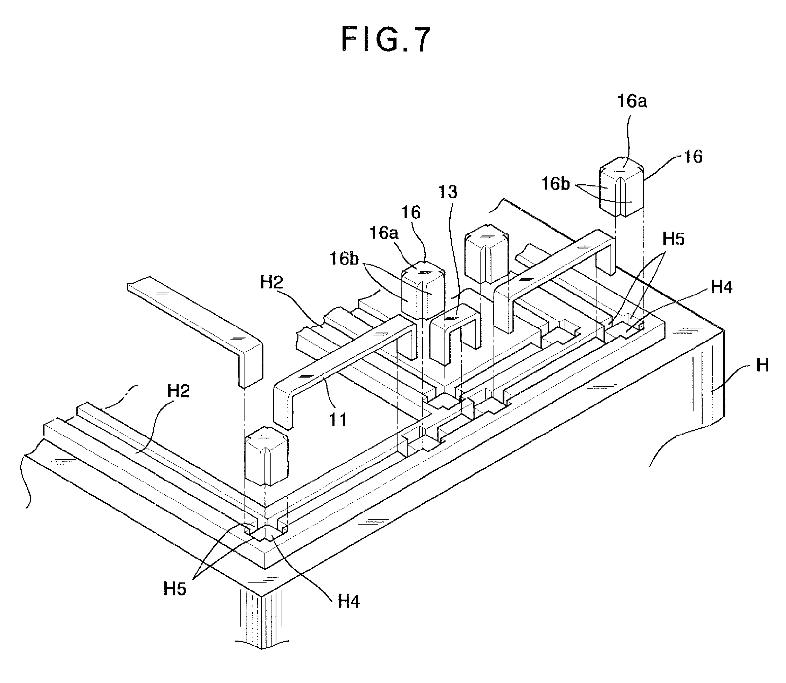

Although L-shaped, T-shaped and cross-shaped members each having contact portions 14a at their ends are employed for corner bus bar segments 14 in the previous embodiment, further two types of corner bus bar segments 16 and 17 as shown in Figs. 7 to 10 may be employed for this purpose.

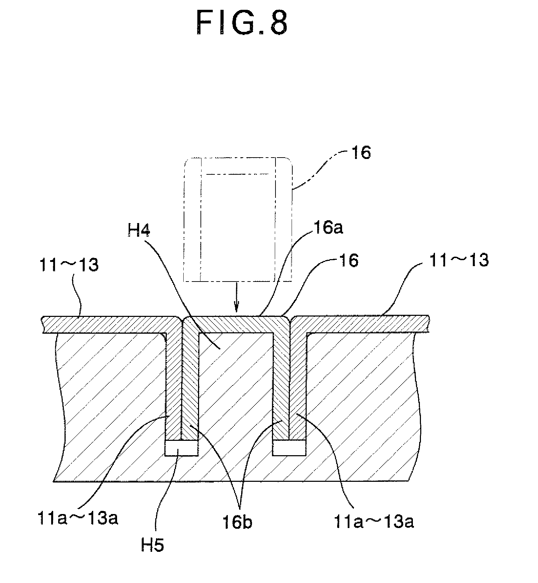

Hereinafter, the bus bar segment 16 will be explained with reference to Fig. 7 and Fig. 8. Said bus bar segment 16 is composed of a top portion 16a in square flat form and four contact portions 16b extending from four sides of said top portion 16a and bent downward. The thus formed corner bus bar segment 16 having four contact portions 16b is intended to be used in a circuit composed of straight bus bar segments 11, 12 or 13 arranged in cross form. In the case of a circuit in which the straight bus bar segments 11, 12 or 13 are arranged in L-form, the bus bar corner segment is modified to have two adjacent contact portions 16b. Similarly, in the case of a circuit in which the straight bus bars segments are arranged in T-form, the bus bar corner segment is modified to have three contact portions 16a. That is, the corner bus bar segment is required to have at least two contact portions 16b. However, since preparing three modifications of this type of corner bus bar segment causes the number of parts to rise, it is preferable to prepare the corner bus bar segment as shown in Fig. 7 having four contact portions extending from all four sides alone.

In order to incorporate said corner bus bar segment 16, the wiring board H is required to have a rectangular pillar H4 formed in a circuit corner to support the top portion 16a of the corner bus bar segment 16 and an insertion hole H5 surrounding said rectangular pillar H4. For connecting the straight bus bar segments 11 through 13 by use of said corner bus bar segment 16, the contact portions 16 of the corner bus bar segment 16 is first inserted into the insertion hole H5 such that the top portion 16a thereof is disposed on said rectangular pillar H4 in the wiring board H. Then, the contact portions 11a through 13a of the straight bus bar segments 11 through 13 are forcibly inserted into said insertion hole H5 such that the straight bus bar segments 11 through 13 are electrically and mechanically connected by way of the corner bus bar segment 16.

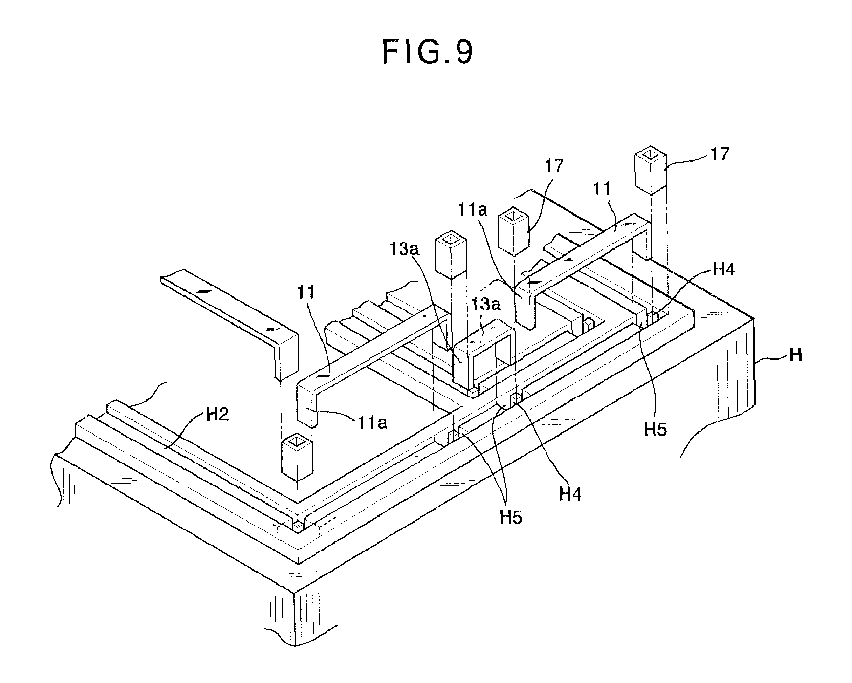

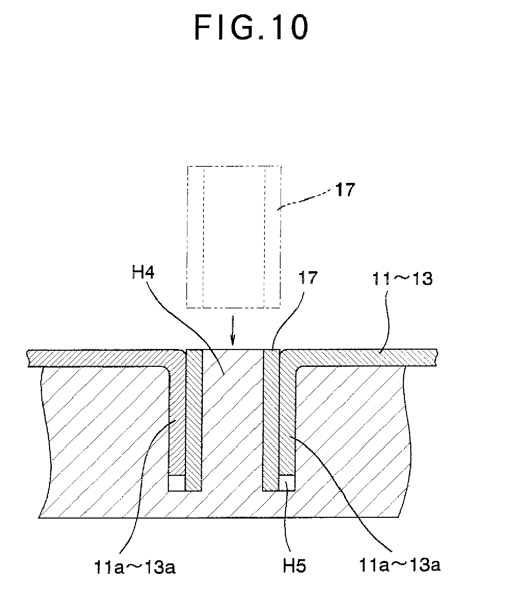

Next, corner bus bar segments 17 shown in Fig. 9 and Fig. 10 will be explained hereinafter. Said corner bus bar segments 17 is prepared in the form of a pipe having a square cross section. For connecting the straight bus bar segments 11 to 13 by use of said corner bus bar segments 17, said corner bus bar segment 17 is forced down along the outer circumference of said rectangular pillar H4, and then, the contact portions 11a to 13a of the straight bus bar segment is forcibly inserted into the insertion hole H5 such that the straight bus bar segment 11 through 13 arranged crisscross are electrically and mechanically connected to each other by way of the corner bus bar segment 17.

With said corner bus bar segment 17, it is possible to connect the straight bus bar segments arranged in L-form and T-form by way of segments L-shaped or channel-shaped or channel shaped as in the embodiments shown in Fig. 7 and Fig. 8.

In this connection, although it is explained in any of the embodiments how the straight bus bar segments 11 to 13 are connected by use of corner bus bar segments 14, 16 or 17, it is needless to say that it is also possible to connect straight bus bar segments 11 through 13 and connector terminals 15 arranged in L-form, T-form or crisscross by use of corner bus bar segments 14, 16 or 17.

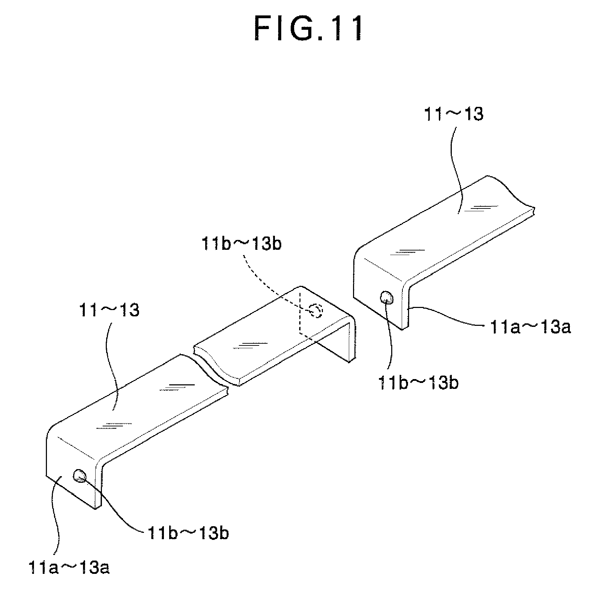

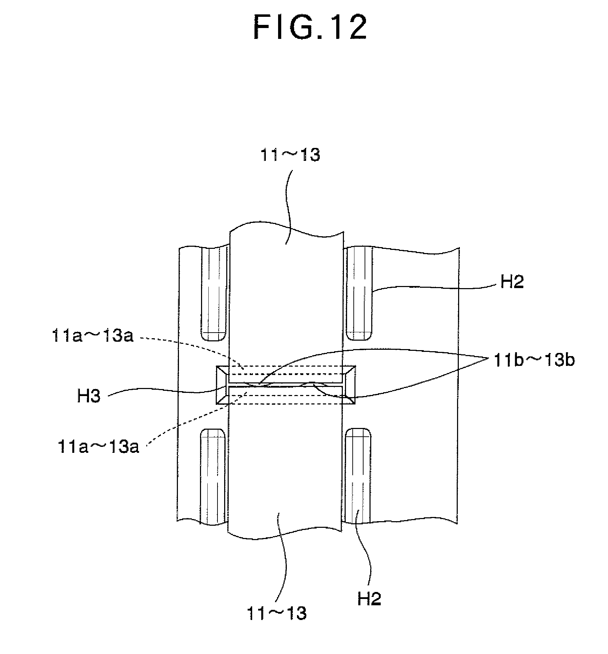

In the previous embodiments, it was explained that the connection of the contact portions 11a to 13a of the straight bus bar segments 11 through 13, the contact portions 14a, 16a, 17a of the corner bus bar segments 14, 16 17 and the contact portions 15a of the connector terminals 15 is secured by making the entry to open relatively wide but converging toward the tip ends thereof to ensure that the contact portions are forcibly connected to each other. Alternatively, the corresponding structure may be designed such that the insertion holes H3 and H4 have straight inner walls while the contact portions 11a -13a are embossed to have at least one protuberance such as those 11b-13b therein in positions not to interfere with each other as shown in the embodiment shown in Fig. 11 and Fig. 12. (Although the straight bus bar segments are shown in the figures, such modification may be made to the contact portions 14a of the corner bus bar segments 14 and the contact portions 15a of the connector terminals 15.)

By thus forming protuberances 11b to 13b in the contact portions 11a to 13a, it is possible to resiliently bring the protuberances 11b to 13b to the opposing flat surfaces of the contact 11a to 13a with the contact portions 11a to 13 being inserted into the insertion holes H3 and H5 of parallel inner walls, it is made possible to make the connection of the contact portions electrically and mechanically secure.

In another embodiment, it is designed that an oval resilient metal , preferably oval, collars 18 are inserted into the insertion holesH3 in the wiring board as shown in Fig. 13 and the contact portions 11a-13a are press fit into said metal collars 18 to ensure that the connection between the contact portions are electrically and mechanically strengthened as done in any one of the preceding embodiments.

As explained in the foregoing, the present invention makes it possible to prepare a straight bus bar on a wiring board out of straight bus bar segments by sequentially connecting the contact portions of the straight bus bar segments electrically each other. Therefore, it is further possible to standardize straight bus bar segments in desired dimensions so as to configure a desired circuit pattern with bus bar segments of small number of types. As a result, the cost reduction is realized by minimizing the production of waste materials which used to be produced by the convention methods of preparing a large number of integral bus bars in accordance with desired circuit patters.

Further, since the opposite ends of the straight bus bar segments are bent to form contact portions which are press fit into insertion holes formed in the wiring board such that neighboring straight bus bars are electrically connected each other, it has become possible to produce a straight circuit portion of different length on the wiring board by preparing a desired number of standardized straight bus bar segments, thus eliminating the need for preparing different sizes of bus bars or punching out large-sized integral bus bars covering the whole circuit configuration. Therefore, the cost reduction is realized as a result of minimizing the waste of materials.

Further, since any circuit pattern is realized with ease by connecting straight bus bar segments arranged on said wiring board if the corner bus bar segments having contact portions of L-shape, T-shape or cross-shape, it is possible to freely design no matter how complicated circuit patter.

Further, since guide grooves are formed in the wiring board to guide said straight bus bar segments and corner bus bar segments, said two types of bus bar segments can be positively connected without deviating from each other, thus allowing automated setting of bus bar segments with ease.

Further, since said insertion hole has an entry opening relatively wide but becoming increasingly narrower in a direction in which the tip end of the contact portion proceeds such that said contact portions inserted into said insertion hole are press fit to each other toward their tip ends such that the electrical contact is assured, thus preventing loose electrical contact.

Further, since the respective contact portions of the straight bus bar segments and the corner bus bar segments are embossed to have protuberances in positions not to interfere with each other, it is possible to assure positive mutual contact of the contact portions and prevent loose electrical connection through the forcible press of the protuberances against the flat surfaces of the contact portions with the contact portions inserted into the insertion holes.

Further, it is possible to prevent loose electrical contact in the electrical contact of the contact portions by forcibly inserting contact portions of both the straight bus bar segments and corner bus bar segments into the insertion hole inserted in advance with an oval collar.

## Claims

1. A wiring board formed with electric circuits, wherein said electric circuits are formed by comprising straight bus bar segments, each of the straight bus bar segments having contact portions at opposite ends thereof, said wiring board having means for bringing the respective contact portions into electrical contact.

2. A wiring board formed with electric circuits, wherein said electric circuits are formed by comprising straight bus bar segments, each of the respective straight-line bus bar segments having contact portions bent at right angles at opposite ends thereof, said wiring board having insertion holes formed to receive the respective contact portions for bringing said respective contact portions into electrical contact.

3. A wiring board formed with electric circuits, wherein said electric circuits are formed by comprising straight bus bar segments and corner bus bar segments, each of said straight bus bar segments and said corner bus bar segments having contact portions at opposite ends thereof, said wiring board having insertion corner holes formed to receive the respective contact portions for bringing said respective contact portions into electrical contact.

4. A wiring board according to claim 3, wherein said corner bus bar segment is L-shaped, T-shaped or cross shaped and has contact portions at respective opposite ends thereof to be received into said insertion corner holes.

5. A wiring board according to claim 3, wherein said corner bus bar segment has a square top surface having four sides, at least two of said four sides being formed with contact portions extending therefrom to be received into said insertion corner holes.

6. A wiring board according to claim 3, wherein said corner bus bar segments are formed with at least two contact portions to be received into said insertion corner holes formed in said wiring board, each of said insertion corner holes including at least two holes combined into one to extend at a fight angle for defining a corner configuration.

7. A wiring board according to any one of claims 1 through 3, wherein said wiring board is formed with guide grooves to guide said straight bus bar segments and said corner bus bar segments, said insertion holes being in said guide grooves.

8. A wiring board according to any one of claims 1 through 3, wherein each insertion hole has an entry opening relatively wide but becoming increasingly narrow in a direction in which the tip end of the contact portion proceeds such that said contact portions inserting into said insertion hole are press fit to each other toward their tip ends.

9. A wiring board according to any one of claims 1 through 3, wherein each contact portion of the straight bus bar segments and the corner bus bar segments is embossed to have at least one protuberance such that when the contact portions of the straight bus bar segments and the contact portions of the corner bus bar segments are inserted into said insertion holes, the protuberance of each mating contact portion are press fit to the flat surface of other mating contact portion to assure the contact therebetween.

10. A wiring board according to any one of claims 1 through 3, wherein an oval is inserted into the insertion holes to assure that the forcibly inserted contact portions of straight bus bar segments each other and the inserted contact portions of straight bus bar segments and corner bus bar segments are brought into positive press fit each other.

11. A wiring board according to any one of claims 1 through 10, wherein all of said straight bus bar segments are of equal length and width.

12. A bus bar segment arrangement in a wiring board comprising a plurality of standardized straight bus bar segments of different lengths and widths, each straight bus bar segment having contact portions bent at its opposite ends; and corner bus bar segments of equal widths to said straight bus bar segments, each corner bus bar segment having contact portions bent at their ends, said corner bus bar segments being L-shaped, T-shaped and cross shaped, respectively.

13. A bus bar segment arrangement in a wiring board comprising a plurality of standardized straight bus bar segments of different lengths and widths, each straight bus bar segment having contact portions bent at its opposite ends; and corner bus bar segments of equal widths to said straight bus bar segments, each corner bus bar segment having a top portion in square flat form and at least two contact portions extending from two neighboring side of said top portion and bent in an uniform direction.

14. A bus bar segment arrangement in a wiring board comprising a plurality of standardized straight bus bar segments of different lengths and widths, each straight bus bar segment having contact portions bent at its opposite ends; and corner bus bar segments of equal widths to said straight bus bar segments, each corner bus bar segment having at least two contact portions bent at a right angle.

15. A bus bar segment arrangement according to any one of claims 12 through 14, wherein said straight bus bar segments and said corner bus bar segments are embossed to have protuberances in positions not to interfere with each other.
